# EUROPEAN PATENT APPLICATION

(11) **EP 4 578 913 A1**
(43) Date of publication of application: **02.07.2025**
(21) Application number: 23864694.7
(22) Date of filing: 12.09.2023
(51) Int. Cl.: C08L 63/00, C08K 3/36, C08G 59/40, H01L 23/29

(54) **RESIN COMPOSITION AND USE THEREOF**

(30) Priority: 15.09.2022 CN 202211119854
(71) Applicant: Huawei Technologies Co., Ltd., Shenzhen, Guangdong 518129 (CN)
(72) Inventor: XU, Weina, Shenzhen, Guangdong 518129 (CN); LIU, Chengjie, Shenzhen, Guangdong 518129 (CN); YUAN, Can, Shenzhen, Guangdong 518129 (CN); JIN, Song, Shenzhen, Guangdong 518129 (CN); ZHU, Xiaoyi, Shenzhen, Guangdong 518129 (CN); CHUANG, Teyi, Shenzhen, Guangdong 518129 (CN); BAO, Xusheng, Shenzhen, Guangdong 518129 (CN)
(74) Representative: Goddar, Heinz J.
(86) International application number: PCT/CN2023/118241
(87) International publication number: WO 2024/055962

(57) **Abstract**

A resin composition is provided. The resin composition includes epoxy resin, a curing agent, and silica powder, where a modal diameter of the silica powder ranges from 18 µm to 22 µm, and a mean diameter of the silica powder ranges from 6 µm to 9 µm. The resin composition can have a low viscosity in case of a high silica powder filling amount, has a low coefficient of thermal expansion CTE and a high glass transition temperature Tg after curing, and can widen a process window, improve filling effect, resolve a warpage problem caused by packaging of an electronic device, and improve service reliability of the electronic device.

## Description

This application claims priority to Chinese Patent Application No. 202211119854.2, filed with the China National Intellectual Property Administration on September 15, 2022 and entitled "RESIN COMPOSITION AND APPLICATION THEREOF", which is incorporated herein by reference in its entirety.

### TECHNICAL FIELD

Embodiments of this application relate to the field of electronic component preparation technologies, and in particular, to a resin composition and application thereof.

### BACKGROUND

With continuous development of information technologies, entire electronic devices are developing towards miniaturization, portability, multi-function, digitalization, high reliability, high performance, and the like. Therefore, internal components of the devices need to be miniaturized, integrated, and modularized. Based on this, advanced packaging technologies such as fan-in wafer level packaging (Fan-in Wafer Level Packaging, FOWLP), fan-out wafer level packaging (Fan-Out Wafer Level Packaging, FOWLP), through silicon via (Through Silicon Via, TSV), 2.5D packaging, 3D packaging, and eWLB (Embedded Wafer Level Ball Grid Array, and embedded wafer level ball grid array) packaging are continuously developed and widely used.

The fan-out wafer level packaging (FOWLP) has features such as substrate-free packaging, thin packaging, low impedance, and a large quantity of I/O interfaces (Input/Output interfaces, that is, input/output interfaces) of a same silicon chip size, which can ensure fast signal transmission and fast calculation of an electronic operation processor to a maximum extent, and can effectively reduce a transmission loss and power consumption, thereby meeting requirements for light weight, thinness, and high performance of the electronic device. A fan-out wafer level packaging (FOWLP) structure is mainly molded through compression molding (Compression molding). A molding material includes a liquid epoxy molding compound (Liquid molding compound, LMC), a granular epoxy molding compound (Granular molding compound, GMC), and a sheet epoxy molding compound (Sheet molding compound, SMC). The LMC is characterized by simple operation, no dust problem, mature technology, and uniform molding, and occupies more than 90% of the market. In the FOWLP, to ensure that the LMC has a sufficient process operation window before compression molding and can implement complete filling, the LMC is required to have a low viscosity and high fluidity. In addition, a cured LMC is coated outside a chip. To ensure reliability of a component in a service process, the LMC is required to have a low coefficient of thermal expansion (coefficient of thermal expansion, CTE), a high glass transition temperature (glass transition temperature, Tg), and low warpage. To improve reliability of the molding compound, a quantity of added inorganic fillers is generally increased as much as possible. However, an increase in content of the inorganic fillers causes a high viscosity of an LMC system and a narrow process window, affecting complete filling. Therefore, it is necessary to provide a liquid epoxy molding compound that can have both a low viscosity and high fluidity, and can have a low coefficient of thermal expansion CTE and a high glass transition temperature Tg after curing.

### SUMMARY

In view of this, embodiments of this application provide a resin composition. The resin composition has a low viscosity, has a low coefficient of thermal expansion CTE and a high glass transition temperature Tg after curing, and can widen a process window, improve filling effect, resolve a wafer warpage problem caused during packaging of an electronic device, and improve packaging reliability of the electronic device.

Specifically, a first aspect of embodiments of this application provides a resin composition. The resin composition includes epoxy resin, a curing agent, and silica powder, where a modal diameter of the silica powder ranges from 18 µm to 22 µm, and a mean diameter of the silica powder ranges from 6 µm to 9 µm.

The resin composition provided in embodiments of this application is in a liquid state at room temperature, and is a liquid resin composition. According to the resin composition, silica powder of multiple different particle sizes is used as a filler, and the modal diameter and the mean diameter of the silica powder are controlled within specific ranges. Large particles of the silica powder are as close as possible to a cut-off particle size (25 µm), and the mean diameter ranges from 6 µm to 9 µm by properly matching the large particles and small particles of the silica powder, so that the resin composition can have a high filling amount (that is, high mass content) of the silica powder and good packaging filling performance. Further, a resin composition system still has a low viscosity and high fluidity when the silica powder filling amount is high, and a coefficient of thermal expansion CTE of a product obtained by curing the resin composition is reduced. The resin composition is used for packaging of an electronic device, can widen a process operation window, and can better implement complete filling to reduce generation of flow marks, and a molded body that is formed after curing and that covers a surface of an electronic component can have a low coefficient of thermal expansion CTE and a high glass transition temperature Tg, thereby improving filling effect and resolving a wafer warpage problem caused during packaging of the electronic device, and improving packaging reliability of the electronic device.

In an implementation of this application, the silica powder is silicon dioxide micropowder obtained by processing natural quartz or fused quartz, and the silica powder is spherical or spherical-like particles. A low coefficient of thermal expansion of the silica powder helps the resin composition system obtain a low coefficient of thermal expansion after curing. The silica powder further has high mechanical strength and low water absorption, which helps improve packaging reliability. The silica powder has a spherical structure or a spherical-like structure, which helps improve fluidity of the resin composition, thereby better implementing filling.

In an implementation of this application, a specific surface area of the silica powder ranges from 1.6 m²/g to 2 m²/g. In this embodiment of this application, the silica powder whose modal diameter and mean diameter are within the specific ranges is used, so that the silica powder has a low specific surface area, thereby better improving fluidity of the resin composition system and improving uniformity of a cured product of the resin composition. In this way, the molded body obtained through curing obtains a more uniform coefficient of thermal expansion CTE, thereby better resolving the warpage problem.

In an implementation of this application, a mass fraction of the silica powder in the resin composition is greater than or equal to 86%. The content of the silica powder is controlled to be high, which helps reduce a coefficient of thermal expansion of a cured product of the resin composition, improve warpage, and improve packaging reliability.

In some implementations of this application, the mass fraction of the silica powder in the resin composition ranges from 86% to 92%. The content of the silica powder is controlled to be within a proper content range as high as possible, so that the resin composition can better balance a low coefficient of thermal expansion and a low viscosity, thereby ensuring process implementability and packaging reliability of the resin composition as a molding compound for an electronic device.

In an implementation of this application, the cut-off particle size (namely, a jammed particle size or a truncated particle size) of the silica powder ranges from 25 µm, and in the silica powder, a mass fraction of silica powder with a particle size greater than 25 µm is less than 1%. The cut-off particle size of the silica powder is controlled to be 25 µm, and content of the silica powder with the particle size greater than 25 µm is controlled to be in an extremely low proportion, so that complete filling can be better implemented.

In an implementation of this application, in the silica powder, a mass fraction of silica powder with a particle size greater than 15 µm is greater than or equal to 20%. In some implementations of this application, in the silica powder, the mass fraction of the silica powder with the particle size greater than 15 µm is greater than or equal to 20% and less than or equal to 35%. The proportion of the silica powder with a larger particle size greater than 15 µm is controlled to be high, so that low viscosity performance of the resin composition can be better implemented.

In an implementation of this application, in the silica powder, a mass fraction of silica powder with a particle size less than 1.5 µm is greater than or equal to 20%. In some implementations of this application, in the silica powder, the mass fraction of the silica powder with the particle size less than 1.5 µm is greater than or equal to 20% and less than or equal to 35%. A proper combination of submicron silica powder and nano silica powder that have small particle sizes can achieve a high filling ratio, improve fluidity, and improve filling performance of the resin composition.

In an implementation of this application, in the silica powder, a mass fraction of silica powder with a particle size less than 0.5 µm is less than or equal to 12%. Content of the nano silica powder with a small particle size is controlled to be low, which helps improve overall fluidity of the resin composition system.

In an implementation of this application, a mass fraction of the curing agent in the resin composition ranges from 3% to 8%. Proper content of the curing agent can enable the resin composition to be smoothly cured, to obtain basic physical properties that meet packaging, and can better ensure that a wafer has low warpage.

In an implementation of this application, a mass fraction of the epoxy resin in the resin composition ranges from 3% to 8%. Proper content of the epoxy resin can enable the resin composition to meet basic physical properties of packaging, to implement filling, and can better ensure that a wafer has low warpage.

In some implementations of this application, in the resin composition, the mass fraction of the silica powder ranges from 86% to 92%, the mass fraction of the curing agent ranges from 3% to 8%, and the mass fraction of the epoxy resin ranges from 3% to 8%. The resin composition in embodiments of this application uses high mass content of the silica powder and a proper proportion of the epoxy resin and a proper proportion of the curing agent, so that overall physical properties of the resin composition system can be better ensured, and the resin composition has a low viscosity, high viscosity stability, a low coefficient of thermal expansion CTE, a high glass transition temperature Tg, high peel strength, low water absorption, and the like and can further reduce wafer warpage and improve packaging reliability of an electronic device.

In an implementation of this application, a mass fraction of the epoxy resin in all organic ingredients in the resin composition ranges from 10% to 55%.

In an implementation of this application, a mass fraction of the curing agent in all the organic ingredients in the resin composition ranges from 10% to 80%. Controlling the mass fractions of the epoxy resin and the curing agent in the organic ingredients within the foregoing ranges can better balance viscosity, cohesion, curing effect, and the like, and can better balance heat shrinkage performance and chemical shrinkage performance of the resin composition, thereby helping resolve the wafer warpage problem.

In an implementation of this application, a ratio of a quantity of epoxy groups of the epoxy resin to a quantity of reactive functional groups of the curing agent ranges from 0.3 to 2. To be specific, a ratio of a quantity of groups that can react of the epoxy resin to a quantity of groups that can react of the curing agent falls within a range of 0.3 to 2. Controlling the ratio of the quantity of groups that can react of the epoxy resin to the quantity of groups that can react of the curing agent within the foregoing range can better balance properties such as the viscosity, the cohesion, the curing effect, and the water absorption, and improve comprehensive properties of the resin composition, and can better balance the heat shrinkage performance and chemical shrinkage performance of the resin composition, thereby helping resolve the wafer warpage problem.

In an implementation of this application, the curing agent includes an anhydride curing agent and/or an amine curing agent. In this implementation of this application, the anhydride curing agent may be one or more of hexahydrophthalic anhydride, tetrahydrophthalic anhydride, methyltetrahydrophthalic anhydride, methylhexahydrophthalic anhydride, hexahydrophthalic anhydride, alkyl hexahydrophthalic anhydride, tetrahydrophthalic anhydride, succinic anhydride, methyl nadic anhydride, hydrogenated methyl nadic anhydride, 5-norbornene-2,3-dicarboxylic anhydride, trialkyltetrahydrophthalic anhydride, and the like. In this implementation of this application, the amine curing agent may be polyetheramine, isophorone diamine, 3,3'-dimethyl-4,4'-diamino-dicyclohexyl methane, or the like. Using the anhydride curing agent helps obtain a low viscosity, fast reaction, and short curing time.

In an implementation of this application, the epoxy resin includes one or more of bisphenol A epoxy resin, bisphenol F epoxy resin, bisphenol AD epoxy resin, bisphenol S epoxy resin, alicyclic epoxy resin, naphthalene epoxy resin, and aminophenol epoxy resin. In the resin composition, there may be one type of epoxy resin, or there may be a combination of multiple (two or more) types of epoxy resin.

In an implementation of this application, to improve performance of the resin composition, the resin composition may further include an additive. The additive includes one or more of a coupling agent, a stress modifier, a curing accelerator, a colorant, a dispersant, an ion trapping agent, a leveling agent, a flame retardant, a mold release agent, and a flow improver. The additive may be added based on a specific requirement.

In an implementation of this application, a viscosity of the resin composition at 25°C and 3 reciprocal seconds is less than 800 Pas. The resin composition in embodiments of this application has a low viscosity at room temperature, and therefore has a wide process operation window. This helps ensure good fluidity and filling performance of the resin composition during molding, better perform a packaging operation, and improve packaging effect.

In an implementation of this application, a viscosity change rate of the resin composition is less than 300% when the resin composition is left to stand for 24 hours at room temperature and 45% humidity. The resin composition has a low viscosity change rate, that is, has high viscosity stability. This facilitates application of the resin composition in a packaging process.

In an implementation of this application, a glass transition temperature of a cured product of the resin composition is greater than or equal to 140°C. The resin composition has a high glass transition temperature Tg after curing, so that service reliability of a molded body obtained through packaging can be improved.

In an implementation of this application, a coefficient of thermal expansion (a coefficient of linear expansion) of the cured product of the resin composition is less than or equal to 10 ppm/K when a temperature of the cured product of the resin composition is below Tg, and the coefficient of thermal expansion is less than or equal to 40 ppm/K when the temperature is above Tg. The cured product of the resin composition has a low coefficient of thermal expansion, so that it can be ensured that the molded body obtained through packaging has high dimensional and structural stability, and service reliability of a packaged device is improved.

A second aspect of embodiments of this application provides a packaging material, used for sealed packaging of an electronic component. The packaging material includes the resin composition according to the first aspect of embodiments of this application and/or a cured product of the resin composition. The resin composition provided in embodiments of this application is used as a packaging material for packaging the electronic component, so that packaging effect can be improved, and service reliability of an electronic device can be improved.

A third aspect of embodiments of this application provides application of the resin composition according to the first aspect in sealed packaging of an electronic component. Specifically, the resin composition is used to form a molded body covering the electronic component, to fasten and protect the electronic component.

A fourth aspect of embodiments of this application provides a cured product. The cured product includes a cured product of the resin composition according to the first aspect of embodiments of this application. The cured product in this embodiment of this application may be formed in various shapes by curing the resin composition as required, and cover a surface of an electronic component that needs to be packaged.

A fifth aspect of embodiments of this application provides a packaged device. The packaged device includes the cured product according to the fourth aspect of embodiments of this application. The packaged device in this embodiment of this application is packaged by using the cured product of the resin composition provided in embodiments of this application, and has high service reliability.

In an implementation of this application, the packaged device includes a substrate, an electronic component disposed on the substrate, and a molded body covering the electronic component, and the molded body includes the cured product. In this application, the electronic component includes but is not limited to a chip. When the electronic component is a chip, the packaged device is a chip packaged structure.

An embodiment of this application further provides a terminal device. The terminal device includes a circuit board and the packaged device according to the fifth aspect of embodiments of this application that is disposed on the circuit board. The terminal device in this embodiment of this application uses the packaged device provided in embodiments of this application, so that service reliability of the terminal device can be improved.

An embodiment of this application further provides a communication device. The communication device includes the packaged device according to the fifth aspect of embodiments of this application.

An embodiment of this application further provides a communication base station. The communication base station includes the packaged device according to the fifth aspect of embodiments of this application.

### BRIEF DESCRIPTION OF DRAWINGS

FIG. 1 is a diagram of a structure of an electronic packaged device 100 according to an embodiment of this application;
FIG. 2 is a diagram in which an electronic packaged device 100 is disposed on a circuit board according to an embodiment of this application; and
FIG. 3 is a diagram of a structure of a terminal device 200 according to an embodiment of this application.

### DESCRIPTION OF EMBODIMENTS

The following describes embodiments of this application with reference to accompanying drawings in embodiments of this application.

In FOWLP, to ensure that a liquid epoxy molding compound LMC has a sufficient process operation window before compression molding and can implement complete filling, the LMC is required to have a low viscosity and high fluidity. In addition, a cured liquid epoxy molding compound LMC is coated outside a chip. To ensure service reliability, the LMC is required to have a low coefficient of thermal expansion CTE, a high glass transition temperature Tg, and low warpage. Currently, it is difficult for the liquid epoxy molding compound LMC to have all the foregoing performance. Therefore, embodiments of this application provide a resin composition. The resin composition is in a liquid state, and is a liquid epoxy molding compound, and the liquid epoxy molding compound can have both a low viscosity and high fluidity, and can have a low coefficient of thermal expansion CTE and a high glass conversion transition Tg after curing. The resin composition may be applied to, but not limited to, advanced packaged structures of fan-in wafer level packaging FOWLP, fan-out wafer level packaging FOWLP, through silicon via TSV, 2.5D packaging, 3D packaging, and embedded wafer level ball grid array eWLB packaging.

An embodiment of this application provides a resin composition. The resin composition includes epoxy resin, a curing agent, and silica powder, where a modal diameter of the silica powder ranges from 18 µm to 22 µm, and a mean diameter of the silica powder ranges from 6 µm to 9 µm.

In an implementation of this application, a modal diameter, namely, a modal particle diameter, is a particle size value corresponding to a highest point of a frequency distribution curve. In an implementation of this application, the modal diameter of the silica powder may be specifically, for example, 18 µm, 19 µm, 20 µm, 21 µm, or 22 µm. In an implementation of this application, a cut-off particle size of the silica powder is 25 µm. In an implementation of this application, the mean diameter of the silica powder may be specifically 6 µm, 7 µm, 8 µm, or 9 µm.

The resin composition provided in this embodiment of this application is in a liquid state at room temperature, and is a liquid resin composition. According to the resin composition, silica powder of multiple different particle sizes is used as a filler, and the modal diameter and the mean diameter of the silica powder are controlled within specific ranges. Large particles of the silica powder are as close as possible to the cut-off particle size (25 µm), and the mean diameter is enabled to range from 6 µm to 9 µm by properly matching the large particles and small particles of the silica powder, so that the resin composition can have a high silica powder filling amount (that is, high mass content) and good packaging filling performance. Further, a resin composition system still has a low viscosity and high fluidity when the silica powder filling amount is high, and a coefficient of thermal expansion CTE of a product obtained by curing the resin composition is reduced. The resin composition is used for packaging of an electronic device, can widen a process operation window, and can better implement complete filling to reduce generation of air holes, gaps, and flow marks, and a molded body that is formed after curing and that covers a surface of an electronic component can have a low coefficient of thermal expansion CTE and a high glass transition temperature Tg, thereby improving filling effect and resolving a warpage problem caused during packaging of the electronic device, and improving packaging reliability of the electronic device.

In an implementation of this application, the silica powder is silicon dioxide micropowder obtained by processing natural quartz or fused quartz, and the silica powder is spherical or spherical-like particles. A low coefficient of thermal expansion of the silica powder helps the resin composition system obtain a low coefficient of thermal expansion after curing. The silica powder further has high mechanical strength and low water absorption, which helps improve packaging reliability. The silica powder has a spherical structure or a spherical-like structure, which helps improve fluidity of the resin composition, thereby better implementing filling.

In an implementation of this application, a specific surface area of the silica powder ranges from 1.6 m²/g to 2 m²/g. A specific surface area is a total area of a material of unit mass. In an implementation of this application, the specific surface area of the silica powder may be specifically 1.6 m²/g, 1.7 m²/g, 1.8 m²/g, 1.9 m²/g, or 2 m²/g. In this embodiment of this application, the silica powder whose modal diameter and mean diameter are within the specific ranges is used, so that the silica powder has a low specific surface area, thereby better improving fluidity of the resin composition system and improving uniformity of a cured product of the resin composition. In this way, the molded body obtained through curing obtains a more uniform coefficient of thermal expansion CTE, thereby better resolving the warpage problem.

In an implementation of this application, a mass fraction of the silica powder in the resin composition is greater than or equal to 86%. The content of the silica powder is controlled to be high, which helps reduce a coefficient of thermal expansion of a cured product of the resin composition, improve warpage, and improve packaging reliability.

In some implementations of this application, the mass fraction of the silica powder in the resin composition ranges from 86% to 92%. Specifically, the mass fraction of the silica powder in the resin composition may be, for example, 86%, 87%, 88%, 89%, 90%, 91%, or 92%. The content of the silica powder is controlled to be within a proper content range as high as possible, so that the resin composition can better balance a low coefficient of thermal expansion and a low viscosity, thereby ensuring process implementability and packaging reliability of the resin composition as a molding compound for an electronic device.

In an implementation of this application, the cut-off particle size of the silica powder is 25 µm, and the cut-off particle size is a jammed particle size or a truncated particle size, and corresponds to a size of a screen for screening the silica powder. For example, if the cut-off particle size of the silica powder is 25 µm, the silica powder is silica powder obtained by screening with a screen with a size of more than 25 µm. It should be noted that, due to a limitation of the screen, impact caused by storage, and the like of the silica powder, there may inevitably be some silica powder particles with particle sizes greater than the cut-off particle size in the silica powder. In some implementations of this application, in the silica powder, a mass fraction of silica powder with a particle size greater than 25 µm is less than 1%, that is, a ratio of mass of the silica powder with the particle size greater than 25 µm in mass of all the silica powder in the resin composition is less than 1%. In some embodiments, in the silica powder, the mass fraction of the silica powder with the particle size greater than 25 µm is less than 0.8%. The cut-off particle size of the silica powder is controlled to be 25 µm, and content of the silica powder with the particle size greater than 25 µm is controlled to be in an extremely low proportion as low as possible, so that filling performance of the resin composition can be improved, and complete filling can be better implemented. This is better applicable to a small-sized narrow-gap filling scenario.

In an implementation of this application, in the silica powder, a mass fraction of silica powder with a particle size greater than 15 µm is greater than or equal to 20%, that is, a ratio of mass of the silica powder with the particle size greater than 15 µm in mass of all the silica powder in the resin composition is greater than or equal to 20%. In some embodiments, in the silica powder, the mass fraction of the silica powder with the particle size greater than 15 µm is greater than or equal to 25%. In some embodiments, in the silica powder, the mass fraction of the silica powder with the particle size greater than 15 µm is greater than or equal to 30%. In some implementations of this application, in the silica powder, the mass fraction of the silica powder with the particle size greater than 15 µm is greater than or equal to 20% and less than or equal to 35%. Specifically, in some embodiments, in the silica powder, the mass fraction of the silica powder with the particle size greater than 15 µm is 20%, 21%, 22%, 23%, 24%, 25%, 26%, 27%, 28%, 29%, 30%, 31%, 32%, 33%, 34%, or 35%. The proportion of the silica powder with a larger particle size greater than 15 µm is controlled to be high, so that low viscosity performance of the resin composition can be better implemented.

In an implementation of this application, in the silica powder, a mass fraction of silica powder with a particle size less than 1.5 µm is greater than or equal to 20%, that is, a ratio of mass of the silica powder with the particle size less than 1.5 µm in mass of all the silica powder in the resin composition is greater than or equal to 20%. In some embodiments, in the silica powder, the mass fraction of the silica powder with the particle size less than 1.5 µm is greater than or equal to 25%. In some embodiments, in the silica powder, the mass fraction of the silica powder with the particle size less than 1.5 µm is greater than or equal to 30%. In some implementations of this application, in the silica powder, the mass fraction of the silica powder with the particle size less than 1.5 µm is greater than or equal to 20% and less than or equal to 35%. Specifically, in some embodiments, in the silica powder, the mass fraction of the silica powder with the particle size less than 1.5 µm is 20%, 21%, 22%, 23%, 24%, 25%, 26%, 27%, 28%, 29%, 30%, 31%, 32%, 33%, 34%, or 35%. A proper combination of submicron silica powder and nano silica powder that have small particle sizes less than 1.5 µm can achieve a high filling ratio (namely, high mass content of the silica powder), improve fluidity, and improve filling performance of the resin composition.

In an implementation of this application, in the silica powder, a mass fraction of silica powder with a particle size less than 0.5 µm is less than or equal to 12%, that is, a ratio of mass of the silica powder with the particle size less than 0.5 µm in mass of all the silica powder in the resin composition is less than or equal to 12%. In some embodiments, in the silica powder, the mass fraction of the silica powder with the particle size less than 0.5 µm is less than or equal to 10%. In some embodiments, in the silica powder, the mass fraction of the silica powder with the particle size less than 0.5 µm is less than or equal to 9%. In some embodiments, in the silica powder, the mass fraction of the silica powder with the particle size less than 0.5 µm is less than or equal to 8%. Content of the nano silica powder with a small particle size is controlled to be low, which helps improve overall fluidity of the resin composition system.

According to the resin composition in this embodiment of this application, when a type of the epoxy resin is determined, a low viscosity in case of a high filler ratio can be achieved by selecting and grading the silica powder within a cut-off particle size range, and selecting and grading of the silica powder may enable the silica powder to be tightly stacked, which is conducive to flow of the system, so that the resin composition has good fluidity. Specifically, when silica powder filling content is the same, the modal diameter is within a range of 18 µm to 22 µm, and the mean diameter ranges from 6 µm to 9 µm, which helps implement a low viscosity in case of a high filler ratio. Further, the specific surface area of the graded silica powder is controlled within a range of 1.6 m²/g to 2 m²/g through narrow particle size distribution, so that the viscosity of the resin composition system is lower. When the mass fraction of the silica powder with the particle size greater than 15 µm is further controlled to be greater than or equal to 20%, the mass fraction of the silica powder with the particle size less than 1.5 µm is further controlled to be greater than or equal to 20%, and/or the mass fraction of the silica powder with the particle size less than 0.5 µm is further controlled to be less than or equal to 12%, the resin composition system may obtain a lower viscosity.

In an implementation of this application, a shape, a size, and particle size distribution of the silica powder may be obtained through analysis by using a scanning electron microscope (scanning electron microscope, SEM), an optical microscope, a laser particle analyzer, or the like.

In an implementation of this application, a mass fraction of the curing agent in the resin composition ranges from 3% to 8%. In some embodiments of this application, the mass fraction of the curing agent in the resin composition may be 3%, 4%, 5%, 6%, 7%, or 8%. Proper content of the curing agent can enable the resin composition to be smoothly cured, to obtain basic physical properties (for example, low viscosity, high viscosity stability, low coefficient of thermal expansion CTE, high glass transition temperature Tg, high peel strength, and low water absorption) that meet packaging, and can better ensure that a wafer has low warpage.

In an implementation of this application, a mass fraction of the epoxy resin in the resin composition ranges from 3% to 8%. In some embodiments of this application, the mass fraction of the epoxy resin in the resin composition may be 3%, 4%, 5%, 6%, 7%, or 8%. Proper content of the epoxy resin can enable the resin composition to meet basic physical properties of packaging, to implement filling, and can better ensure that a wafer has low warpage.

In some implementations of this application, in the resin composition, the mass fraction of the silica powder ranges from 86% to 92%, the mass fraction of the curing agent ranges from 3% to 8%, and the mass fraction of the epoxy resin ranges from 3% to 8%. The resin composition in this embodiment of this application uses high mass content of the silica powder and a proper proportion of the epoxy resin and a proper proportion of the curing agent, so that overall physical properties of the resin composition system can be better ensured, and the resin composition has a low viscosity, high viscosity stability (namely, a low viscosity change rate), a low coefficient of thermal expansion CTE, a high glass transition temperature Tg, high peel strength, low water absorption, and the like and can further reduce wafer warpage and improve packaging reliability of an electronic device.

A warpage size of a wafer obtained through compression molding by using a liquid epoxy molding compound LMC is not only related to silica powder, but also closely related to shrinkage of a packaging material. The shrinkage includes two parts: heat shrinkage and chemical shrinkage. An amplitude of heat shrinkage and an amplitude of chemical shrinkage are inversely proportional to each other. In this application, the proportion of the epoxy resin and the proportion of the curing agent are balanced, to obtain a liquid epoxy molding compound with better warpage.

In an implementation of this application, a mass fraction of the epoxy resin in all organic ingredients in the resin composition ranges from 10% to 55%. In some embodiments, the mass fraction of the epoxy resin in all the organic ingredients in the resin composition ranges from 15% to 45%. In some embodiments, the mass fraction of the resin composition in all the organic ingredients in the epoxy resin ranges from 25% to 40%. In an implementation of this application, a mass fraction of the curing agent in all the organic ingredients in the resin composition ranges from 10% to 80%. In some implementations, the mass fraction of the curing agent in all the organic ingredients in the resin composition ranges from 20% to 70%. In some implementations, the mass fraction of the curing agent in all the organic ingredients in the resin composition ranges from 30% to 60%. Controlling the mass fractions of the epoxy resin and the curing agent in the organic ingredients within the foregoing ranges can better balance viscosity, cohesion, curing effect, a glass transition temperature Tg, and the like, and can better balance heat shrinkage performance and chemical shrinkage performance of the resin composition, thereby helping resolve the wafer warpage problem.

In an implementation of this application, a ratio of a quantity of epoxy groups of the epoxy resin to a quantity of reactive functional groups of the curing agent ranges from 0.3 to 2. To be specific, a ratio of the quantity of epoxy groups in the epoxy resin to a quantity of groups that can react of the curing agent falls within a range of 0.3 to 2. In some embodiments, the ratio of the quantity of epoxy groups of the epoxy resin to the quantity of reactive functional groups of the curing agent ranges from 0.5 to 1.8. In some embodiments, the ratio of the quantity of epoxy groups of the epoxy resin to the quantity of reactive functional groups of the curing agent ranges from 0.7 to 1.6. Controlling a ratio of a quantity of groups that can react of the epoxy resin to the quantity of groups that can react of the curing agent within the foregoing range can better balance properties such as the viscosity, the cohesion, the curing effect, the water absorption, and the glass transition temperature Tg, and improve comprehensive properties of the resin composition, and can better balance the heat shrinkage performance and the chemical shrinkage performance of the resin composition, thereby helping resolve the wafer warpage problem.

In an implementation of this application, the epoxy resin may include one or more of bisphenol A epoxy resin, bisphenol F epoxy resin, bisphenol AD epoxy resin, bisphenol S epoxy resin, alicyclic epoxy resin, naphthalene epoxy resin, and aminophenol epoxy resin. In the resin composition, there may be one type of epoxy resin, or there may be a combination of multiple (two or more) types of epoxy resin. Multiple types of epoxy resin are combined for use, so that the resin composition can obtain better comprehensive performance, for example, can balance viscosity and cohesion.

In an implementation of this application, the curing agent may include an anhydride curing agent and/or an amine curing agent. For example, the anhydride curing agent may be hexahydrophthalic anhydride, tetrahydrophthalic anhydride, methyltetrahydrophthalic anhydride, methylhexahydrophthalic anhydride, hexahydrophthalic anhydride, alkyl hexahydrophthalic anhydride, tetrahydrophthalic anhydride, succinic anhydride, methyl nadic anhydride, hydrogenated methyl nadic anhydride, 5-norbornene-2,3-dicarboxylic anhydride, trialkyltetrahydrophthalic anhydride, and the like. For example, the amine curing agent may be polyetheramine, isophorone diamine, 3,3'-dimethyl-4,4'-diamino-dicyclohexyl methane, or the like. Using the anhydride curing agent helps obtain a low viscosity, fast reaction, and short curing time. The resin composition in this application may include one type of curing agent, or may include multiple (two or more) types of curing agents.

In an implementation of this application, a type of the epoxy resin and a type of the curing agent may be obtained through analysis by using methods such as a nuclear magnetic resonance spectrogram, an infrared spectrometer, and element analysis.

In an implementation of this application, to improve performance of the resin composition, the resin composition may further include an additive. The additive includes but is not limited to one or more of a coupling agent, a stress modifier, a curing accelerator, a colorant, a dispersant, an ion trapping agent, a leveling agent, a flame retardant, a mold release agent, and a flow improver. The additive may be added based on a specific requirement. In this implementation of this application, specific types of the coupling agent, the stress modifier, the curing accelerator, the colorant, the dispersant, the ion trapping agent, the leveling agent, the flame retardant, the mold release agent, and the flow improver are not specially limited. The curing accelerator includes but is not limited to one or more of tertiary amine (for example, N,N-dimethyl benzylamine), imidazole, and modified imidazole (for example, dimethylimidazole and 1-phenyl dimethylimidazole). In this implementation of this application, total content of the additive in the resin composition is controlled to be less than 5%. In some embodiments, the total content of the additive in the resin composition is controlled to be less than 4%.

In an implementation of this application, a viscosity of the resin composition at 25°C and 3 reciprocal seconds is less than 800 Pas. In some implementations, the viscosity of the resin composition at 25°C and 3 reciprocal seconds is less than 700 Pas. In some implementations, the viscosity of the resin composition at 25°C and 3 reciprocal seconds is less than 600 Pas. In some implementations, the viscosity of the resin composition at 25°C and 3 reciprocal seconds is less than 500 Pas. In some implementations, the viscosity of the resin composition at 25°C and 3 reciprocal seconds is less than 400 Pas. In some implementations, the viscosity of the resin composition at 25°C and 3 reciprocal seconds is less than 300 Pas. The viscosity of the resin composition may be tested by using a rheometer. It should be noted that the resin composition in this embodiment of this application needs to be stored and transported at a low temperature of -40°C or below. The viscosity η at 25°C and 3 reciprocal seconds refers to a viscosity measured when the resin composition is just prepared through mixing, or a viscosity measured after thawing. The resin composition in this embodiment of this application has a low viscosity at room temperature, and therefore has a wide process operation window. This helps ensure good fluidity and filling performance of the resin composition during molding, better perform a packaging operation, and improve packaging effect.

In an implementation of this application, a viscosity change rate of the resin composition is less than 300% when the resin composition is left to stand for 24 hours at room temperature and 45% humidity. In some implementations, the viscosity change rate of the resin composition is less than or equal to 200% when the resin composition is left to stand for 24 hours at room temperature and 45% humidity. In some implementations, the viscosity change rate of the resin composition is less than or equal to 100% when the resin composition is left to stand for 24 hours at room temperature and 45% humidity. In some implementations, the viscosity change rate of the resin composition is less than or equal to 90% when the resin composition is left to stand for 24 hours at room temperature and 45% humidity. The viscosity change rate is a change rate of a viscosity change amount △η, measured after the resin composition is thawed, and is left to stand for 24 hours at room temperature and 45% humidity, relative to an initial viscosity measured before standing , where △η=viscosity measured after 24 hours-initial viscosity, viscosity change rate=(△η/initial viscosity)* 100%, and the initial viscosity is a viscosity measured after the resin composition is thawed. The resin composition has a low viscosity change rate, that is, the resin composition has high viscosity stability. This can facilitate application of the resin composition in a packaging process.

In an implementation of this application, a glass transition temperature of a cured product of the resin composition is greater than or equal to 140°C. In some implementations, the glass transition temperature of the cured product of the resin composition is greater than or equal to 150°C. The resin composition has a high glass transition temperature Tg after curing, so that service reliability of a molded body obtained through packaging can be improved.

In an implementation of this application, a coefficient of thermal expansion of the cured product of the resin composition is less than or equal to 10 ppm/K when a temperature of the cured product of the resin composition is below Tg, and the coefficient of thermal expansion is less than or equal to 40 ppm/K when the temperature is above Tg. In some implementations, the coefficient of thermal expansion of the cured product of the resin composition is less than or equal to 9 ppm/K when the temperature of the cured product of the resin composition is below Tg. In some implementations, the coefficient of thermal expansion of the cured product of the resin composition is less than or equal to 8 ppm/K when the temperature of the cured product of the resin composition is below Tg. In some implementations, the coefficient of thermal expansion of the cured product of the resin composition is less than or equal to 38 ppm/K when the temperature of the cured product of the resin composition is above Tg. In some implementations, the coefficient of thermal expansion of the cured product of the resin composition is less than or equal to 37 ppm/K when the temperature of the cured product of the resin composition is above Tg. The cured product of the resin composition has a low coefficient of thermal expansion, so that it can be ensured that the molded body obtained through packaging has high dimensional stability and structural stability, and service reliability of a packaged device is improved.

The resin composition in this embodiment of this application may be prepared by stirring and mixing ingredients. The stirring and mixing may be performed by using a top-mounted mechanical stirrer, a dual-planetary mixer, a homogenizer, or a three-roll grinding machine alone, or may be performed by using a combination of the foregoing apparatuses.

The resin composition in this embodiment of this application is cured after being heated. To be specific, the epoxy resin and the curing agent in the resin composition may chemically react to form a three-dimensional mesh polymer. The resin composition is converted into a cured product of a specific shape after curing, and the cured product may be a thin film, a sheet, or a three-dimensional structure. The foregoing resin composition in this application is usually in a liquid state. The liquid resin composition may be directly used as liquid glue, and may form an adhesive layer after coating, filling, and curing. In addition, the resin composition may be further converted, through processing such as mixing and aging, into a solid-state molding material that is easy to preserve (the epoxy resin is not completely cross-linked and cured). The molding material may be granular, sheet-like, or clumpy. Subsequently, the molding material may be converted into a cured product of a specific shape by using a common molding process.

The resin composition in this embodiment of this application is an epoxy resin composition including the silica powder of a high filling ratio. The resin composition can effectively reduce a coefficient of thermal expansion CTE of a system and have a low viscosity, and may be applied to, but not limited to, advanced packaged structures of fan-in wafer level packaging FOWLP, fan-out wafer level packaging FOWLP, through silicon via TSV, 2.5D packaging, 3D packaging, and embedded wafer level ball grid array eWLB packaging, and a product (for example, a processor) using the advanced packaged structures may be used in an entire device, for example, a mobile phone, a computer, or an automobile. The resin composition in this application may be further applied to large-area molding, thin packaging without grinding, passive device packaging, POP (package-on-package, package-on-package) packaging, and the like. These packaged products may be used in devices such as wireless apparatuses and self-driving sensors of mobile electronic devices.

An embodiment of this application provides a packaging material. The packaging material is an electronic packaging material, and is used for sealed packaging of an electronic component. The packaging material includes the foregoing resin composition provided in embodiments of this application and/or a cured product of the foregoing resin composition. The foregoing resin composition provided in embodiments of this application is used as a packaging material for packaging the electronic component, so that packaging effect can be improved, and service reliability of an electronic device can be improved.

An embodiment of this application provides application of the foregoing resin composition in the field of electronic packaging, and specifically application of the resin composition in sealed packaging of an electronic component. In this embodiment of this application, the electronic component may be a chip, a transistor (for example, a diode or a triode), an LED, a resistor-capacitor-inductor element (for example, a resistor, a capacitor, or an inductor), or the like. A structural form of packaging may be an advanced packaged structure of fan-in wafer level packaging FOWLP, fan-out wafer level packaging FOWLP, through silicon via TSV, 2.5D packaging, 3D packaging, or embedded wafer level ball grid array eWLB packaging, or may be a packaged structure of large-area molding, thin packaging without grinding, passive device packaging, or POP (package-on-package, package-on-package) packaging.

An embodiment of this application further provides a cured product. The cured product includes a cured product of the foregoing resin composition in embodiments of this application. The cured product may be in a shape of a thin film, a sheet, a three-dimensional structure, or the like. The cured product is characterized by low coefficient of thermal expansion CTE, high glass transition temperature Tg, high mechanical strength, low water absorption, and the like, and can form a molded body to better protect various electronic components.

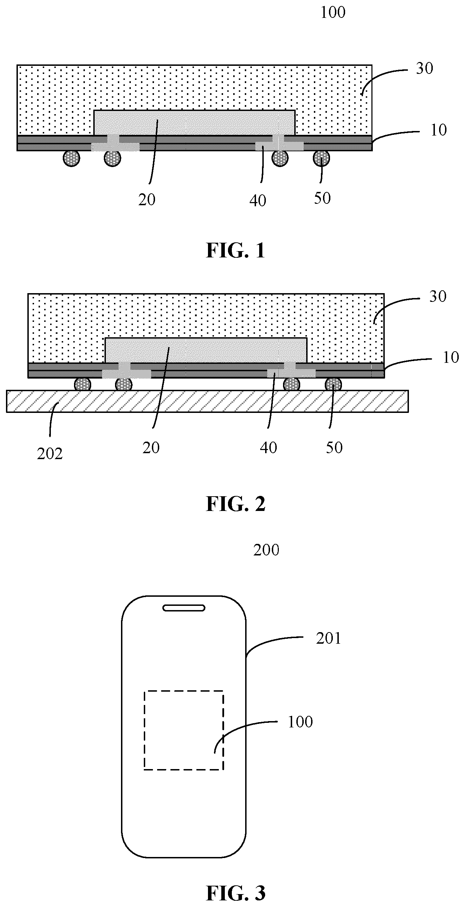

Refer to FIG. 1. An embodiment of this application further provides a packaged device 100. FIG. 1 is a diagram of a structure of the packaged device 100 according to an implementation of this application. The packaged device 100 may be an electronic packaged device, and the packaged device 100 includes a cured product of the foregoing resin composition in embodiments of this application. Specifically, the packaged device 100 includes a substrate 10, an electronic component 20 disposed on the substrate 10, and a molded body 30 that packages and coats the substrate 10 and the electronic component 20 in a sealed manner. The electronic component 20 may be various components that need to be packaged, including but not limited to one or more of a chip, a transistor (for example, a diode or a triode), an LED, and a resistor-capacitor-inductor element (for example, a resistor, a capacitor, or an inductor). The following provides specific descriptions by using an example in which the electronic component 20 is a chip. The chip may be attached to a surface of the substrate 10 through soldering, and the substrate 10 may be a redistribution layer (RDL). A plurality of metal balls 50 (for example, solder balls) may be disposed on a side that is of the substrate 10 and that is away from the chip, and the metal balls 50 are electrically connected to the chip via conductive structures 40 in the substrate 10. Refer to FIG. 2. The packaged device 100 may be soldered to a circuit board 202 via the metal balls 50, and the electronic component 20 in the packaged device 100 may be electrically connected to the circuit board 202 via the conductive structures 40 and the metal balls 50. The molded body 30 uses the resin composition in embodiments of this application. In other words, the molded body 30 includes a cured product of the resin composition in embodiments of this application. The molded body 30 may be processed into a specific structural appearance from the resin composition by using common molding processes such as a transfer molding (transfer molding) method, a compression molding (compression molding) method, or an injection molding (injection molding) method. In addition, epoxy resin is cross-linked and cured during molding.

According to the packaged device in this application, the electronic component is packaged by using the resin composition provided in embodiments of this application, so that process operability is high, and packaging reliability is high.

Refer to FIG. 3. An embodiment of this application further provides a terminal device 200. The terminal device 200 includes a housing 201, and a circuit board and a packaged device 100 that are disposed in the housing 201. Inside the terminal device 200, the packaged device 100 may be disposed on a circuit board 202 as shown in FIG. 2, and is electrically connected to the circuit board 202. The terminal device 200 may be a product, for example, a mobile phone, a tablet computer, a notebook computer, a portable computer, an intelligent wearable product, a television, a video recorder, a video camera recorder, a radio set, a radio-tape recorder, a vehicle-mounted terminal, a mouse, a keyboard, a microphone, or a scanner.

An embodiment of this application further provides a communication device. The communication device includes the foregoing packaged device 100 in embodiments of this application. The packaged device 100 may be electrically fastened to a circuit board. The communication device may be various wired communication devices or wireless communication devices, including but not limited to a communication conversion device, a lightning arrester, an antenna, a gateway, a remote control, a radar, a walkie-talkie, a switch, and a router.

An embodiment of this application further provides a communication base station. The communication base station includes the foregoing packaged device 100 in embodiments of this application. The packaged device 100 may be electrically fastened to a circuit board.

Embodiments of this application are further described below by using a plurality of embodiments.

### Embodiment 1

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 9 µm, a modal diameter is 18 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 2

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 7 µm, a modal diameter is 18 µm, and a specific surface area is 1.8 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 3

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 6 µm, a modal diameter is 18 µm, and a specific surface area is 2 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 4

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 5

A resin composition is provided. The resin composition is obtained by stirring and uniformly mixing ingredients in the following mass fractions: 3.68% of epoxy resin, 4.52% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.72% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 6

A resin composition is provided. The resin composition is obtained by stirring and uniformly mixing ingredients in the following mass fractions: 3.68% of epoxy resin, 4.10% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 2.12% of first epoxy resin and 1.88% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 7

A resin composition is provided. The resin composition is obtained by stirring and uniformly mixing ingredients in the following mass fractions: 3.68% of epoxy resin, 4.23% of second curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 3.87% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 8

A resin composition is provided. The resin composition is obtained by stirring and uniformly mixing ingredients in the following mass fractions: 3.68% of epoxy resin, 4.11% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 2.21% of second epoxy resin and 1.78% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 9

A resin composition is provided. The resin composition is obtained by stirring and uniformly mixing ingredients in the following mass fractions: 3.68% of epoxy resin, 3.74% of second curing agent, 89% of silica powder, 0.25% of coupling agent, 0.45% of stress modifier, 1.4% of curing accelerator, 1% of colorant, 0.4% of dispersant, and 0.4% of ion trapping agent, where the epoxy resin includes 3.36% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 10

A resin composition is provided. The resin composition is obtained by stirring and uniformly mixing ingredients in the following mass fractions: 3.68% of epoxy resin, 4.78% of second curing agent, 87% of silica powder, 0.25% of coupling agent, 0.45% of stress modifier, 1.4% of curing accelerator, 1% of colorant, 0.4% of dispersant, and 0.4% of ion trapping agent, where the epoxy resin includes 4.32% of third epoxy resin; a cut-off particle size of the silica powder is 25 µm, a mean diameter of the silica powder is 8 µm, a modal diameter is 22 µm, and a specific surface area is 1.6 m²/g; and in the silica powder, a mass fraction of silica powder with a particle size greater than 25 µm is less than 1%, a mass fraction of silica powder with a particle size greater than 15 µm is within a range of 20% to 35%, a mass fraction of silica powder with a particle size less than 1.5 µm is within a range of 20% to 35%, and a mass fraction of silica powder with a particle size less than 0.5 µm is less than or equal to 12%.

### Embodiment 11

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 9 µm, a modal diameter is 18 µm, and a specific surface area is 1.6 m²/g; and in the silica powder, a mass fraction of silica powder with a particle size greater than 25 µm is less than 1%, a mass fraction of silica powder with a particle size greater than 15 µm is 18%, a mass fraction of silica powder with a particle size less than 1.5 µm is 18%, and a mass fraction of silica powder with a particle size less than 0.5 µm is 13%.

### Embodiment 12

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 9 µm, a modal diameter is 18 µm, and a specific surface area is 1.6 m²/g; and in the silica powder, a mass fraction of silica powder with a particle size greater than 25 µm is less than 1%, a mass fraction of silica powder with a particle size greater than 15 µm is 37%, a mass fraction of silica powder with a particle size less than 1.5 µm is 37%, and a mass fraction of silica powder with a particle size less than 0.5 µm is 13%.

### Comparative example 1

A resin composition is provided. The resin composition is obtained by stirring and uniformly mixing ingredients in the following mass fractions: 3.68% of epoxy resin, 4.42% of first curing agent, 88% of silica powder, 0.25% of coupling agent, 0.45% of stress modifier, 1.4% of curing accelerator, 1% of colorant, 0.4% of dispersant, and 0.4% of ion trapping agent, where the epoxy resin includes 1.86% of first epoxy resin and 1.82% of second epoxy resin; a cut-off particle size of the silica powder is 25 µm, a mean diameter of the silica powder is 5 µm, a modal diameter is 16 µm, and a specific surface area is 2.2 m²/g; and in the silica powder, a mass fraction of silica powder with a particle size greater than 25 µm is less than 1%, a mass fraction of silica powder with a particle size greater than 15 µm is 15%, and a mass fraction of silica powder with a particle size less than 1.5 µm is 37%.

Formulas of Embodiments 1 to 12 and Comparative example 1 are listed in Table 1. In the foregoing embodiments and comparative example, the first epoxy resin is bisphenol epoxy resin, the second epoxy resin is alicyclic epoxy resin, and the third epoxy resin is naphthalene epoxy resin. The first curing agent is methylhexahydrophthalic anhydride, and the second curing agent is methyl tetrahydrophthalic anhydride.

A viscosity test is performed on the resin compositions prepared in Embodiment 1 to Embodiment 12 of this application and the resin composition prepared in Comparative example 1. The viscosity test includes a room-temperature initial viscosity test, and a room-temperature viscosity test performed after 24 hours of standing at room temperature and 45% humidity, and the room-temperature viscosity test is specifically to test a viscosity at 25°C and 3 reciprocal seconds. A glass transition temperature Tg test, a coefficient of thermal expansion CTE test, a water absorption test, a filling performance test, and a warpage test are performed on cured products of the resin compositions prepared in Embodiment 1 to Embodiment 12 of this application and a cured product of the resin composition in Comparative example 1. Results of a room-temperature initial viscosity of the resin composition, a room-temperature viscosity of the resin composition obtained after 24 hours of standing, and results of a coefficient of thermal expansion (namely, CTE 1) when temperature is below a glass transition temperature Tg, a coefficient of thermal expansion (namely, CTE 2) when the temperature is above Tg, a water absorption, filling performance, and warpage of the cured product of the resin composition are shown in Table 1. The viscosity of the resin composition is measured by using a rheometer. The coefficient of thermal expansion CTE of the cured product of the resin composition is obtained by using a thermomechanical analysis (TMA) test. The glass transition temperature Tg is measured by using a dynamic thermomechanical analyzer. The water absorption test is performed by using a PCT test (generally referred to as a pressure cooker test or saturated steam test).

Filling performance and warpage test method: 50 g of liquid resin composition is glue-dispensed at a center of a 12-inch bare silicon wafer, and a compression molding device is used to perform compression molding at 125°C for 10 minutes. Then, a surface of the wafer is observed. If the surface is completely filled, the filling performance is qualified. If there is an area not completely filled, the filling performance is unqualified. After compression molding ends, curing is performed at 150°C for one hour. Then, the wafer is placed on a plane to test its warpage. If the warpage is less than 2 µm, the warpage is excellent. If the warpage ranges from 2 µm to 3 µm, the warpage is good. If the warpage is greater than 3 µm, the warpage is poor.

**Table 1 Summary of test results of the embodiments and the comparative example**

| Ingredients and parameters | | Embo dimen t 1 | Embo dimen t 2 | Embo dimen t 3 | Embo dimen t 4 | Embo dimen t 5 | Embo dimen t 6 | Embo dimen t 7 | Embo dimen t 8 | Embo dimen t 9 | Embo dimen t 10 | Embod iment 11 | Embod iment 12 | Compa rative examp le 1 |
|---|---|---|---|---|---|---|---|---|---|---|---|---|---|---|
| Silica powder | | 88 | 88 | 88 | 88 | 88 | 88 | 88 | 88 | 89 | 87 | 88 | 88 | 88 |
| First epoxy resin | | 1.86 | 1.86 | 1.86 | 1.86 | 1.86 | 2.12 | | | | | 1.86 | 1.86 | 1.86 |
| Second epoxy resin | | 1.82 | 1.82 | 1.82 | 1.82 | | | | 2.21 | | | 1.82 | 1.82 | 1.82 |
| Third epoxy resin | | | | | | 1.72 | 1.88 | 3.87 | 1.78 | 3.36 | 4.32 | | | |
| First curing agent | | 4.42 | 4.42 | 4.42 | 4.42 | 4.52 | | | 4.11 | | | 4.42 | 4.42 | 4.42 |
| Second curing agent | | | | | | | 4.10 | 4.23 | | 3.74 | 4.78 | | | |
| Coupling agent | | 0.25 | 0.25 | 0.25 | 0.25 | 0.25 | 0.25 | 0.25 | 0.25 | 0.25 | 0.25 | 0.25 | 0.25 | 0.25 |
| Stress modifier | | 0.45 | 0.45 | 0.45 | 0.45 | 0.45 | 0.45 | 0.45 | 0.45 | 0.45 | 0.45 | 0.45 | 0.45 | 0.45 |
| Curing accelerator | | 1.40 | 1.40 | 1.40 | 1.40 | 1.40 | 1.40 | 1.40 | 1.40 | 1.40 | 1.40 | 1.40 | 1.40 | 1.40 |
| Colorant | | 0.40 | 0.40 | 0.40 | 0.40 | 0.40 | 0.40 | 0.40 | 0.40 | 0.40 | 0.40 | 0.40 | 0.40 | 0.40 |
| Dispersant | | 1.00 | 1.00 | 1.00 | 1.00 | 1.00 | 1.00 | 1.00 | 1.00 | 1.00 | 1.00 | 1.00 | 1.00 | 1.00 |
| Ion trapping agent | | 0.40 | 0.40 | 0.40 | 0.40 | 0.40 | 0.40 | 0.40 | 0.40 | 0.40 | 0.40 | 0.40 | 0.40 | 0.40 |
| Total | | 100 | 100 | 100 | 100 | 100 | 100 | 100 | 100 | 100 | 100 | 100 | 100 | 100 |
| Result assessme nt | Room-tempera ture initial viscosit y (Pa.s) | 270 | 310 | 360 | 220 | 230 | 210 | 215 | 220 | 235 | 210 | 650 | 680 | 1000 |
| | Room-tempera ture viscosit y obtaine d after 24 | 400 | 520 | 590 | 380 | 420 | 370 | 400 | 410 | 430 | 370 | 1400 | 1550 | 2100 |
| | hours of standin g (Pa.s) | | | | | | | | | | | | | |
| | CTE-1 (ppm/K ) | 8 | 8 | 8 | 8 | 8 | 8 | 8 | 8 | 7 | 9 | 8 | 8 | 8 |
| | CTE-2 (ppm/K ) | 36 | 36 | 36 | 36 | 36 | 36 | 36 | 36 | 35 | 37 | 36 | 36 | 36 |
| | Tg (°C) | 150 | 150 | 150 | 150 | 151 | 152 | 155 | 153 | 154 | 152 | 150 | 150 | 150 |
| | Water absorpti on (wt%) | 0.14 | 0.14 | 0.14 | 0.14 | 0.14 | 0.13 | 0.12 | 0.13 | 0.11 | 0.15 | 0.14 | 0.14 | 0.14 |
| | Filling perform ance | Qualif ied | Qualif ied | Qualif ied | Qualif ied | Qualif ied | Qualif ied | Qualif ied | Qualif ied | Qualif ied | Qualif ied | Qualifi ed | Qualifi ed | Unqua lified |
| | Warpag e | Good | Good | Good | Good | Good | Good | Good | Good | Excell ent | Good | Excelle nt | Excelle nt | Poor |

The cut-off particle size of the silica powder selected in embodiments of this application is 25 µm. It can be learned from the results of the foregoing embodiments and the comparative example that, the resin compositions in Embodiment 1 to Embodiment 12 of this application can achieve a low viscosity in case of a high filler ratio through selecting and grading of the silica powder, and the cured product has a low coefficient of thermal expansion CTE, a high glass transition temperature Tg, a low water absorption, good filling performance, and low warpage. This is because selecting and grading the silica powder within a cut-off particle size range can enable the silica powder to be tightly stacked, which is conducive to flow of a system, so that the resin composition has good fluidity. It can be further learned from the results of the foregoing embodiments that, the modal diameter of the silica powder is controlled to be within the range of 18 µm to 22 µm, the mean diameter is controlled to be within 6 µm to 9 µm, and the specific surface area is controlled to be within the range of 1.6 m²/g to 2 m²/g, which is conducive to achieving a low viscosity in case of a high filler ratio; and when the mass fraction of the silica powder with the particle size greater than 15 µm is controlled to be within the range of 20% to 35%, the mass fraction of the silica powder with the particle size less than 1.5 µm is controlled to be within the range of 20% to 35%, and the mass fraction of the silica powder with the particle size less than 0.5 µm is controlled to be less than or equal to 12%, a viscosity of the resin composition system may be greatly reduced, so that a resin composition with a lower viscosity can be obtained.

In addition, in Embodiment 8 to Embodiment 10, the total content of the silica powder is adjusted, and it can be found that the coefficient of thermal expansion CTE of the cured product of the resin composition decreases with the increase of the content of the silica powder. Therefore, when a viscosity meets a requirement, the content of the silica powder may be increased as much as possible, to obtain a lower coefficient of thermal expansion, reduce wafer warpage, and better meet an application requirement in the electronic packaging field. In addition, in this application, a proper curing agent is selected, and a proportion of the epoxy resin and a proportion of the curing agent are controlled to be within proper ranges, so that a glass transition temperature Tg of the resin composition system can be increased, to obtain a packaging material with better warpage.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate the following three cases: Only A exists, both A and B exist, and only B exists, where A and B may be singular or plural. A character "/" generally indicates an "or" relationship between the associated objects.

In this application, "at least one" means one or more, and "a plurality of" means two or more. "At least one of the following items (pieces)" or a similar expression thereof means any combination of these items, including any combination of singular items (pieces) or plural items (pieces). For example, "at least one of a, b, or c", or "at least one of a, b, and c" may indicate: a, b, c, a-b (namely, a and b), a-c, b-c, or a-b-c, where a, b, and c may be singular or plural.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A resin composition, wherein the resin composition comprises epoxy resin, a curing agent, and silica powder, wherein a modal diameter of the silica powder ranges from 18 µm to 22 µm, and a mean diameter of the silica powder ranges from 6 µm to 9 µm.

2. The resin composition according to claim 1, wherein a specific surface area of the silica powder ranges from 1.6 m²/g to 2 m²/g.

3. The resin composition according to claim 1 or 2, wherein a cut-off particle size of the silica powder is 25 µm, and in the silica powder, a mass fraction of silica powder with a particle size greater than 25 µm is less than 1%.

4. The resin composition according to any one of claims 1 to 3, wherein in the silica powder, a mass fraction of silica powder with a particle size greater than 15 µm is greater than or equal to 20%.

5. The resin composition according to claim 4, wherein in the silica powder, the mass fraction of the silica powder with the particle size greater than 15 µm is greater than or equal to 20% and less than or equal to 35%.

6. The resin composition according to any one of claims 1 to 5, wherein in the silica powder, a mass fraction of silica powder with a particle size less than 1.5 µm is greater than or equal to 20%.

7. The resin composition according to claim 6, wherein in the silica powder, the mass fraction of the silica powder with the particle size less than 1.5 µm is greater than or equal to 20% and less than or equal to 35%.

8. The resin composition according to any one of claims 1 to 7, wherein in the silica powder, a mass fraction of silica powder with a particle size less than 0.5 µm is less than or equal to 12%.

9. The resin composition according to any one of claims 1 to 8, wherein a mass fraction of the silica powder in the resin composition is greater than or equal to 86%.

10. The resin composition according to claim 9, wherein the mass fraction of the silica powder in the resin composition ranges from 86% to 92%.

11. The resin composition according to any one of claims 1 to 10, wherein a mass fraction of the curing agent in the resin composition ranges from 3% to 8%.

12. The resin composition according to any one of claims 1 to 11, wherein a mass fraction of the epoxy resin in the resin composition ranges from 3% to 8%.

13. The resin composition according to any one of claims 1 to 12, wherein a mass fraction of the epoxy resin in all organic ingredients in the resin composition ranges from 10% to 55%.

14. The resin composition according to any one of claims 1 to 13, wherein a mass fraction of the curing agent in all the organic ingredients in the resin composition ranges from 10% to 80%.

15. The resin composition according to any one of claims 1 to 14, wherein a ratio of a quantity of epoxy groups of the epoxy resin to a quantity of reactive functional groups of the curing agent ranges from 0.3 to 2.

16. The resin composition according to any one of claims 1 to 15, wherein the curing agent comprises an anhydride curing agent and/or an amine curing agent.

17. The resin composition according to any one of claims 1 to 16, wherein the epoxy resin comprises one or more of bisphenol A epoxy resin, bisphenol F epoxy resin, bisphenol AD epoxy resin, bisphenol S epoxy resin, alicyclic epoxy resin, naphthalene epoxy resin, and aminophenol epoxy resin.

18. The resin composition according to any one of claims 1 to 17, wherein the resin composition further comprises an additive, and the additive comprises one or more of a coupling agent, a stress modifier, a curing accelerator, a colorant, a dispersant, an ion trapping agent, a leveling agent, a flame retardant, a mold release agent, and a flow improver.

19. The resin composition according to any one of claims 1 to 18, wherein a viscosity of the resin composition at 25°C and 3 reciprocal seconds is less than 800 Pas.

20. The resin composition according to any one of claims 1 to 19, wherein a viscosity change rate of the resin composition is less than 300% when the resin composition is left to stand for 24 hours at room temperature and 45% humidity.

21. The resin composition according to any one of claims 1 to 20, wherein a glass transition temperature of a cured product of the resin composition is greater than or equal to 140°C.

22. The resin composition according to any one of claims 1 to 21, wherein a coefficient of thermal expansion of the cured product of the resin composition is less than or equal to 10 ppm/K when a temperature of the cured product of the resin composition is below Tg, and the coefficient of thermal expansion is less than or equal to 40 ppm/K when the temperature is above Tg.

23. A packaging material, used for sealed packaging of an electronic component, wherein the packaging material comprises the resin composition according to any one of claims 1 to 22 and/or a cured product of the resin composition.

24. Application of the resin composition according to any one of claims 1 to 22 in sealed packaging of an electronic component.

25. A cured product, wherein the cured product comprises a cured product of the resin composition according to any one of claims 1 to 22.

26. A packaged device, wherein the packaged device comprises the cured product according to claim 25.

27. The packaged device according to claim 26, wherein the packaged device comprises a substrate, an electronic component disposed on the substrate, and a molded body covering the electronic component, and the molded body comprises the cured product.

28. A terminal device, wherein the terminal device comprises a circuit board and the packaged device according to claim 26 or 27 that is disposed on the circuit board.

29. A communication device, wherein the communication device comprises the packaged device according to claim 26 or 27.

30. A communication base station, wherein the communication base station comprises the packaged device according to claim 26 or 27.
